# EUROPEAN PATENT APPLICATION

(11) **EP 4 421 861 A1**
(43) Date of publication of application: **28.08.2024**
(21) Application number: 24151847.1
(22) Date of filing: 15.01.2024
(51) Int. Cl.: H01L 21/82, H01L 29/06, H01L 29/417, H01L 29/775

(54) **SEMICONDUCTOR DEVICE INCLUDING BACKSIDE CONTACT STRUCTURE**

(30) Priority: 24.02.2023 US 202363448142 P; 29.06.2023 US 202318215985
(71) Applicant: Samsung Electronics Co., Ltd., Suwon-si, Gyeonggi-do 16677 (KR)
(72) Inventor: YUN, Seungchan, San Jose, CA, 95134 (US); HONG, Wonhyuk, San Jose, CA, 95134 (US); PARK, Keumseok, San Jose, CA, 95134 (US); PARK, Se Jung, San Jose, 95134 (US); SEO, Kang-ill, San Jose, 95134 (US)
(74) Representative: Kuhnen & Wacker Patent- und Rechtsanwaltsbüro PartG mbB

(57) **Abstract**

Provided is a semiconductor device including: a channel structure; source/drain regions connected by the channel structure; and a backside contact structure formed below at least one of the source/drain region, wherein, in a 1^{st}-direction cross section view, a width of an upper portion of the backside contact structure close to the source/drain region is smaller than a width of a lower portion of the backside contact structure distant from the source/drain region, wherein, in a 2^{nd}-direction cross-section view, widths of the upper portion and the lower portion of the backside contact structure are substantially uniform along a vertical downward direction, and wherein the 1^{st} direction intersects the 2^{nd} direction.

## Description

### BACKGROUND

### 1. Field

Apparatuses and methods consistent with example embodiments of the disclosure relate to a semiconductor device with a backside contact structure.

### 2. Description of Related Art

A backside power distribution network (BSPDN) structure disposed at a back side of the field-effect transistor has been introduced to address a routing complexity at a back-end-of-line (BEOL) process of a semiconductor device including a field-effect transistor, and prevent excessive IR drop at a front side of the semiconductor device.

The BSPDN structure includes, for example, a backside contact structure and a backside metal line. The backside contact structure may contact a bottom surface of a source/drain region of the field-effect transistor to connect the source/drain region to a circuit element or a voltage source or through the backside metal line, which may be a backside power rail.

The field-effect transistor herein includes a fin field-effect transistor (FinFET), a nanosheet transistor, etc. The FinFET has one or more horizontally arranged vertical fin structures as a channel structure of which at least three surfaces are surrounded by a gate structure, and the nanosheet transistor is characterized by one or more nanosheet channel layers vertically stacked on a substrate as a channel structure, and a gate structure surrounding all four surfaces of each of the nanosheet channel layers. The nanosheet transistor is referred to as gate-all-around (GAA) transistor, multi-bridge channel field-effect transistor (MBCFET).

Information disclosed in this Background section has already been known to the inventors before achieving the embodiments of the present application or is technical information acquired in the process of achieving the embodiments described herein. Therefore, it may contain information that does not form prior art that is already known to the public.

### SUMMARY

Various example embodiments provide a semiconductor device including a backside contact structure.

According to an embodiment, there is provided a semiconductor device which may include: a channel structure; source/drain regions connected by the channel structure; and a backside contact structure formed below at least one of the source/drain region, wherein in a 1^{st}-direction cross section view, a width of an upper portion of the backside contact structure close to the source/drain region is smaller than a width of a lower portion of the backside contact structure distant from the source/drain region, wherein, in a 2^{nd}-direction cross-section view, widths of the upper portion and the lower portion of the backside contact structure are substantially uniform along a vertical downward direction, and wherein the 1^{st} direction intersects the 2^{nd} direction. The semiconductor device may further include a backside isolation structure surrounding the backside contact structure.

According to an embodiment, in the 1^{st}-direction cross-section view, the width of the upper portion is substantially uniform along the vertical downward direction, and the width of the lower portion increases along the vertical downward direction.

According to an embodiment, there is provided a semiconductor device which may include: a channel structure; source/drain regions connected by the channel structure; and a backside contact structure formed below at least one of the source/drain regions, wherein, in a 1^{st}-direction cross-section view, the backside contact structure comprises a side surface in a positive slope from a bottom surface thereof, wherein, in a 2^{nd}-direction cross-section view, widths of the upper portion and the lower portion of the backside contact structure are substantially uniform along a vertical downward direction, and wherein the 1^{st} direction intersects the 2^{nd} direction.

According to an embodiment, in the 1^{st}-direction cross-section view, the backside contact structure may not include a side surface in a negative slope from the bottom surface thereof.

According to an embodiment, there is provided a method of manufacturing a semiconductor device. The method may include: forming source/drain regions at both ends of a channel structure on a substrate; forming a placeholder structure below at least one of the source/drain regions in the substrate; replacing the substrate with a backside isolation structure; epitaxially growing a lower portion of the placeholder structure, being closer to the source/drain region than an upper portion thereof, such that the lower portion has a 1^{st} side surface in a positive slope and a 2^{nd} side surface in a negative slope, connected to the 1^{st} side surface, from a bottom surface of the placeholder structure; removing a section of the epitaxially-grown lower portion of the placeholder structure having the 2^{nd} side surface in the negative slope; and replacing the placeholder structure, from which the section of the epitaxially-grown lower portion is removed, with a backside contact structure.

### BRIEF DESCRIPTION OF DRAWINGS

Example embodiments of the disclosure will be more clearly understood from the following detailed description taken in conjunction with the accompanying drawings in which:
FIGS. 1 and 2A-2J illustrate intermediate semiconductor devices after respective operations in a process of manufacturing a semiconductor device including a backside contact structure, according to embodiments;
FIGS. 3 to 5A-5B illustrate intermediate semiconductor devices after respective operations in a process of manufacturing a semiconductor device including a backside contact structure, according to embodiments;
FIG. 6 is a flowchart illustrating a method of manufacturing a semiconductor device including a backside contact structure, according to embodiments; and
FIG. 7 is a schematic block diagram illustrating an electronic device including a backside contact structure, as shown in FIGS. 4I and 5B, according to an embodiment

### DETAILED DESCRIPTION OF EMBODIMENTS

The embodiments of the disclosure described herein are example embodiments, and thus, the disclosure is not limited thereto, and may be realized in various other forms. Each of the embodiments provided herein is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it is to be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof.

It is to be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the drawings. It is to be understood that the spatially relative terms are intended to encompass different orientations of a semiconductor device in use or operation in addition to the orientation depicted in the drawings. For example, if the semiconductor device in the drawings is turned over, elements described as "below" or "beneath" other elements would then be oriented "above" the other elements. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "lower" element and an "upper" element" may be an "upper" element and a "lower" element when a device or structure including these elements are differently oriented. Thus, in the descriptions herebelow, the "lower" element and the "upper" element may also be referred to as a "1^{st}" element or a "2^{nd}" element, respectively, as long as their structural relationship is clearly understood in the context of the descriptions. Similarly, the terms a "left" element and a "right" element may be respectively referred to as a "1^{st}" element and a "2^{nd}" element with necessary descriptions to distinguish the two elements.

It is to be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element described in one embodiment herein could be termed a 2^{nd} element in another embodiment or claims of the disclosure without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It is to be understood that various elements shown in the drawings are schematic illustrations not drawn to scale. In addition, for ease of explanation, one or more elements of a type commonly used to form semiconductor devices may not be explicitly shown in the drawings without implying these elements are omitted from actual semiconductor devices. Furthermore, it is to be understood that the embodiments described herein are not limited to particular materials, features, and manufacturing steps or operations shown or described herein. Thus, with respect to semiconductor manufacturing steps, the descriptions provided herein are not intended to include all steps that may be required to form an actual semiconductor device. For example, the commonly-used steps such as planarizing, cleaning, or annealing steps may not be described herein for the sake of brevity. It is to be also understood that, even if a certain step or operation is described later than another step or operation, the step or operation may be performed later than the other step or operation unless the other step or operation is described as being performed after the step or operation.

Many embodiments are described herein with reference to cross-sectional views that are schematic illustrations of the embodiments. As such, variations from the shapes of the illustrations as a result, for example, of manufacturing techniques and/or tolerances, are to be expected. Thus, the embodiments should not be construed as limited to the particular shapes of elements illustrated herein but are to include deviations in shapes that result, for example, from manufacturing. Various elements illustrated in the drawings are schematic in nature and their shapes are not intended to illustrate the actual shape of an element of a semiconductor device and are not intended to limit the scope of the disclosure. Moreover, conventional elements of a semiconductor device and their functions, materials and shapes may not be described when these elements are not related to the novel features of the embodiments or not necessary in describing the same.

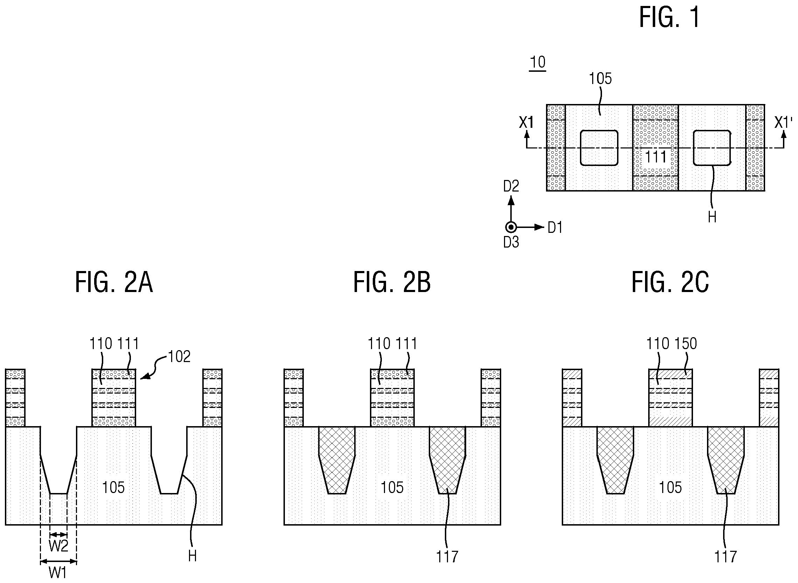

Herebelow, various embodiments of the disclosure will be described in reference to FIGS. 1 to 6.

FIGS. 1 and 2A-2F illustrate intermediate semiconductor devices after respective operations in a process of manufacturing a semiconductor device including a backside contact structure, according to embodiments.

FIG. 1 is a top plan view of an intermediate semiconductor device according to an embodiment, and FIG. 2A is a cross-section view of the intermediate semiconductor device of FIG. 1 taken along lines X1-X1' shown in FIG. 1. FIGS. 2B-2I are cross-section views of respective intermediate semiconductor devices corresponding to FIG. 2A.

It is to be understood that FIG. 1 is provided to help understanding of a positional relationship of a gate structure, a channel structure surrounded by the gate structure, source/drain regions, and placeholder structures for contact structures of an intermediate semiconductor device.

Referring to FIGS. 1 and 2A, an intermediate semiconductor device 10 may include a plurality of nanosheet stacks 102 arranged in a D1 direction and formed on a substrate 105. Each of the nanosheet stacks 102 may include nanosheet layers 110 and sacrificial layers 111 alternatingly stacked on the substrate 105. The nanosheet layers 110 are to form a channel structure of a nanosheet transistor when the intermediate semiconductor device 10 is finished as a semiconductor device. The substrate 105 is exposed between the nanosheet stacks 102, and a hole H is formed in the exposed substrate 105.

The formation of the hole H may be performed by etching the substrate 105 through, for example, dry etching or wet etching, not being limited thereto. As the etching step is performed from a top surface of the substrate 105 down to inside the substrate 105, the hole H may have an upper width W1 which is greater than a lower width W2 in the D1 direction. The D1 direction may be a channel-length direction intersecting a D2 direction which is a channel-width direction in the intermediate semiconductor device 10. Both the D1 direction and the D2 direction may be a horizontal direction perpendicular to a D3 direction. As will be described in the next step, the hole H is provided to accommodate a placeholder for a backside contact structure connected to a source/drain region.

Referring to FIG. 2B, the hole H may be filled in with a placeholder material such as silicon germanium (SiGe) through, for example, physical vapor deposition (PVD), chemical vapor deposition (CVD), atomic layer deposition (ALD), plasma enhanced CVD (PECVD), or a combination thereof, not being limited thereto.

Referring to FIG. 2C, the sacrificial layers 111 in the nanosheet stack 102 may be removed and replaced by a gate structure 150. The sacrificial layers 111 may be removed along with a dummy gate structure formed on the nanosheet stack 102 through, for example, by dry etching, wet etching, reactive ion etching (RIE) and/or a chemical oxide removal (COR) process. The gate structure 150 may be formed through, for example, ALD, PVD, CVD, PECVD or a combination thereof, not being limited thereto.

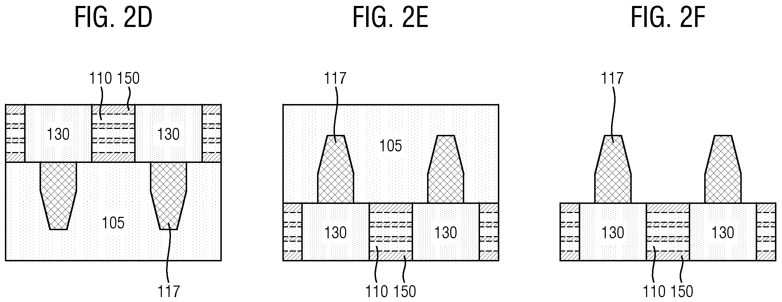

Referring to FIG. 2D, two source/drain regions 130 may be formed on the substrate 105. The source/drain regions 130 may be epitaxially grown from the substrate and/or the nanosheet layers 110. The source/drain regions 130 may be connected to each other through the nanosheet layers 110, which is now a channel structure 110, surrounded by the gate structure 150.

As the source/drain regions 130 are formed, the placeholder structure 117 in the substrate 105 may contact a bottom surface of the source/drain regions 130. The placeholder structure 117 is formed in the substrate 105 to reserve a space for forming a backside contact structure in a later step.

Referring to FIG. 2E, the intermediate semiconductor device 10 of FIG. 2D may be flipped upside down for subsequent operations.

As the intermediate semiconductor device 10 is flipped upside down, a bottom surface of the substrate 105 may be directed upward, and a front side structure such as the source/drain regions 130, the gate structure 150 and the channel structures 110 may be disposed below the substrate 105 in which the placeholder structures 117 are formed.

Referring to FIG. 2F, the substrate 105 may be removed from the intermediate semiconductor device 10 of FIG. 2B. The removal of the substrate 105 may be performed through, for example, dry etching or wet etching.

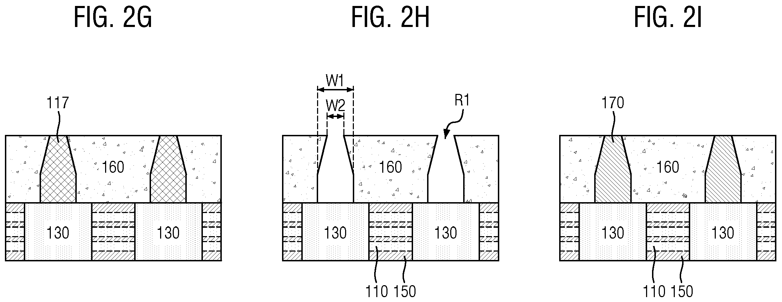

Referring to FIG. 2G, an isolation structure 160 may be formed in to fill the space where the substrate 105 was occupying in the intermediate semiconductor device 10 before removed in the previous step. Thus, the placeholder structure 117 may now be buried in the isolation structure 160.

The formation of the isolation structure 160 may be performed through, for example, depositing a dielectric material such as silicon oxide (e.g., SiO, SiO₂, etc.) in the space of the removed substrate 105 through, for example, CVD, PECVD, PVD, ALD, or a combination thereof, not being limited thereto.

After the isolation structure 160 is formed, the intermediate semiconductor device 10 may be planarized at it top portion through, for example, a chemical-mechanical planarization (CMP) operation to expose a bottom surface of the placeholder structure 117, which is a top surface thereof in FIG. 2D after the intermediate semiconductor device 10 is flipped upside down in the previous step.

The isolation structure 160 may be formed to isolate or electrically insulate a backside contact structure to replace the placeholder structure 117 in a later step from other circuit elements including another backside contact structure. The isolation structure 160 may be referred to as a backside isolation structure because it is formed at a back side of the intermediate semiconductor device 10.

Referring to FIG. 2H, the placeholder structure 117 on each of the source/drain regions 130 may be removed through, for example, wet etching or dry etching, to form a recess R1 in the isolation structure 160. The recess R1 may expose a bottom surface of each of the source/drain regions 130, which is a top surface thereof in FIG. 2E after the intermediate semiconductor device 10 is flipped upside down in the previous step.

Like the placeholder structure 117, the recess R1 may also have the lower width W2 which is smaller than the upper width W1 in the D1 direction.

It is to be understood here that, if there is a buffer layer (or barrier layer) formed on the top surface of each of the source/drain regions 130 in a previous step, the buffer layer may be exposed by the recess R1 in this step.

Referring to FIG. 2I, a backside contact structure 170 may be formed in the recess R1 to be connected to the bottom surface of each of the source/drain regions 130. That is, the backside contact structure 170 may now replaces the placeholder structure 117 which is removed in the previous step.

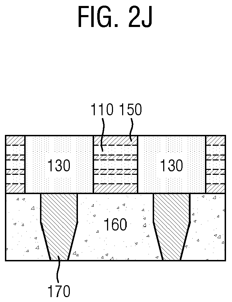

Referring to FIG. 2J, the intermediate semiconductor device 10 obtained in the previous step may be flipped upside down so that the backside contact structures 170 and the isolation structure 160 may be disposed below the source/drain regions 130 to form a semiconductor device.

The formation of the backside contact structure 170 in the recess R1 as shown in FIG. 2F may be performed by depositing in the recess R1 a metal or metal compound including copper (Cu), aluminum (Al), tungsten (W), molybdenum (Mo), ruthenium (Ru), cobalt (Co), etc., through, for example, CVD, PECVD, PVD, ALD, or a combination thereof, not being limited thereto. However, because the lower width L2 of the recess R1 through which the metal or metal compound is deposited is smaller than the upper width W1, the formation of backside contact structure 170 may become incomplete as the metal or metal compound may not sufficiently fill in the recess R1. Thus, a void portion may be formed in the backside contact structure 170, which may lead to insufficient metal connection between the source/drain region 130 and the backside contact structure 170 causing degradation of a device performance.

Accordingly, an improved method of manufacturing a semiconductor device including a backside contact structure is provided herebelow.

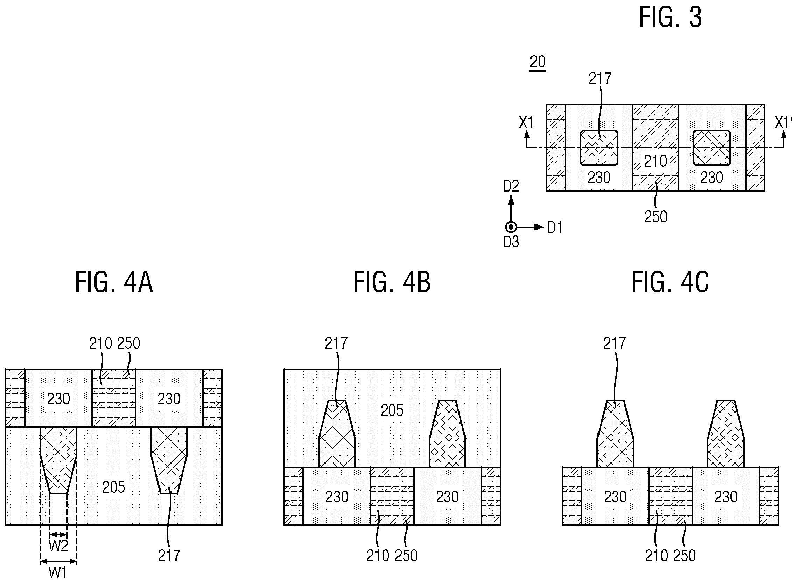

FIGS. 3 to 4A-4I illustrate intermediate semiconductor devices after respective operations in a process of manufacturing a semiconductor device including a backside contact structure, according to embodiments.

FIG. 3 is a top plan view of an intermediate semiconductor device according to an embodiment, and FIG. 4A is a cross-section view of the intermediate semiconductor device of FIG. 3 taken along lines X1-X1' shown in FIG. 3. FIGS. 4B-4I are cross-section views of respective intermediate semiconductor devices corresponding to FIG. 4A.

Similar to FIG. 1, it is to be understood that FIG. 3 is also provided to help understanding of a positional relationship of a gate structure, a channel structure surrounded by the gate structure, source/drain regions, and placeholder structures for contact structures of an intermediate semiconductor device.

Referring to FIGS. 3 and 4A, an intermediate semiconductor device 20 may include, on a substrate 205, two source/drain regions 230 connected to each other through a channel structure 210 surrounded by a gate structure 250. The intermediate semiconductor device 20 shown in FIGS. 3 and 3A corresponds to or is the same as the intermediate semiconductor device 10 of FIGS. 1 and 2A. Thus, duplicate descriptions may be omitted herebelow.

According to an embodiment, a placeholder structure 217 may be formed in the substrate 205 to contact a bottom surface of each source/drain region 230. Each placeholder structure 217 may also be formed of silicon germanium (SiGe) in a hole H obtained by etching the substrate 205 in a manner similar to the formation of the placeholder structure 117 in the previous embodiment.

Referring to FIG. 4B, the intermediate semiconductor device 20 of FIG. 4A may be flipped upside down for subsequent operations.

As the intermediate semiconductor device 20 is flipped upside down, a bottom surface of the substrate 205 may be directed upward, and a front side structure such as the source/drain regions 230, the gate structure 250 and the channel structures 210 may be disposed below the substrate 205 in which the placeholder structures 217 are formed.

Referring to FIG. 4C, the substrate 205 may be removed from the intermediate semiconductor device 10 of FIG. 2B. The removal of the substrate 105 may be performed through, for example, dry etching or wet etching.

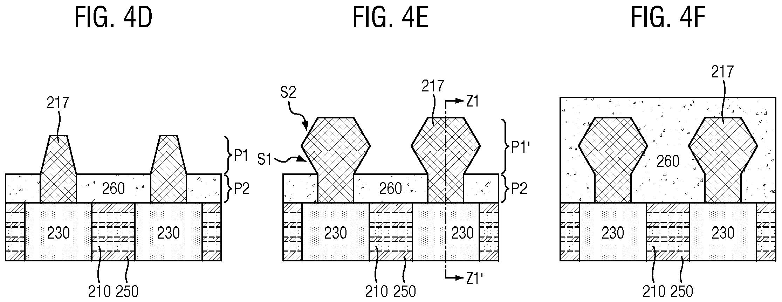

Referring to FIG. 4D, an isolation structure 260 may be formed to fill the space where the substrate 205 was occupying in the intermediate semiconductor device 20 before removed in the previous step, and then, the isolation structure 260 may be partially recessed to partially expose each of the placeholder structures 217 such that a portion P1 of the placeholder structure 217 is protruded from a top surface of the isolation structure 260 while a remaining portion P2 of the placeholder structure 217 is buried in the isolation structure 260.

The formation of the isolation structure 260 may be performed through, for example, depositing a dielectric material such as silicon oxide (e.g., SiO, SiO₂, etc.) in the space of the removed substrate 205 through, for example, CVD, PECVD, PVD, ALD, or a combination thereof, not being limited thereto. The partial recess of the isolation structure 260 may be performed through, for example, dry etching or wet etching.

Referring to FIG. 4E, the protruded portion P1 of each placeholder structure 217 may be enlarged by epitaxially growing SiGe, which forms the placeholder structures 217. The terms "epitaxial growth" and "epitaxially growing" mean growth of a semiconductor material (SiGe) on a deposition surface of a semiconductor material (SiGe), in which the semiconductor material being grown may have the same crystalline characteristics as the semiconductor material of the deposition surface.

The epitaxial growth of the placeholder structure 217 in this step may be performed such that SiGe is grown in outward directions from the protruded portion P1 including the D1 direction and the D3 direction except the D2 direction to form an enlarged portion P1' as shown in FIG. 4E. Thus, the enlarged portion P 1' may have an increase width in the D1 direction and an increase height in the D3 direction in the cross-section view in the channel-length direction (i.e., D1 direction).

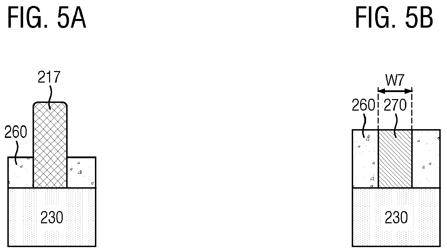

The enlarged portion P 1' may take a hexagon shape, for example, which has a lower segment with a positive-slope side surface S 1 and an upper segment with a negative-slope side surface S2. However, in a cross-section view in the channel-width direction (i.e., D2 direction) along a line Z1-Z1' of in FIG. 4E, the placeholder structure 217 including the enlarged portion P 1' may take a pillar shape having both side surfaces are vertically plane, as shown in FIG. 5A. Further, in this cross-section view of FIG. 5A, a width of the enlarged portion P1' may be equal or substantially equal to that of the protruded portion P1 before enlarged.

The shape of the enlarged portion P 1' of the placeholder structure 217 is not limited to hexagon. According to embodiments, the epitaxial growth may be performed to form the enlarged potion P1' to have a different shape (e.g., pentagon, circle, oval, etc.) in the cross-section view in the channel-length direction as long as the positive slope S1 is formed at a side surface of the enlarged portion P1', while the placeholder structure 217 still has the same pillar shape in the cross-section view in the channel-width direction.

Referring to FIG. 4F, the isolation structure 260 which is partially recessed in the previous step to expose the protruded portion P1 of the placeholder structure 217 may be enlarged by depositing thereon an additional dielectric material such as silicon oxide (e.g., SiO, SiO₂, etc.) such that the enlarged portion P 1' of each of the placeholder structures 217 is buried in the enlarged isolation structure 260.

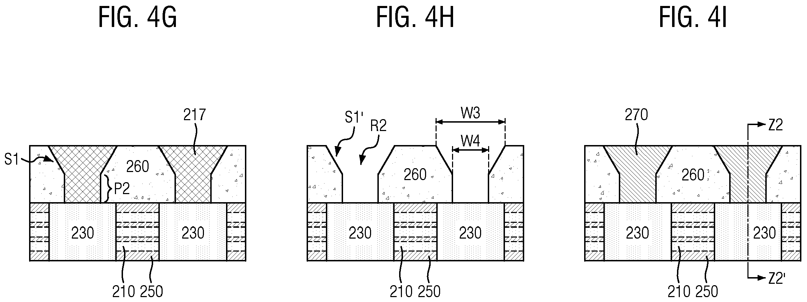

Referring to FIG. 4G, the intermediate semiconductor device 20 obtained in the previous step may be planarized to remove the upper segment of the enlarged portion P 1' of each of the placeholder structures 217 having the negative-slope side surface S2 and an upper portion of the enlarged isolation structure 260 at a side of this upper segment of the enlarged portion P 1' of each of the placeholder structures 217.

By this planarization operation, the lower segment of the enlarged portion P 1' having the positive-slope side surface S1 and the remaining portion P2 of each placeholder structure 217 may remain in the isolation structure 260, having a profile of a "fat Y" in this view. For example, the placeholder structure 217 may have an upper portion, of which a width is substantially constant along a vertical downward direction, and a lower portion of which a width increases along the vertical downward direction. The planarization operation in this step may be performed through, for example, chemical-mechanical polishing (CMP).

Referring to FIG. 4H, the placeholder structure 217 on each of the source/drain regions 230 may be entirely removed through, for example, wet etching or dry etching, to form a recess R2 in the isolation structure 260. The recess R2 may expose 260 a bottom surface of each of the source/drain regions 230, which is a top surface thereof in FIG. 4H after the intermediate semiconductor device 20 is flipped upside down in the previous step.

Like the planarized placeholder structure 217 in the FIG. 4G, the recess R2 may have a positive slope at its side surface S1' and may not have a negative slope. A lower width W4 of the recess R2 in the D1 direction may be the same as the upper width W1 of the placeholder structure 217 shown in FIG. 4A, and this lower width W4 may be smaller than an upper width W3, that is, the recess R2 maintains the "fat Y" profile.

It is to be understood here that, if there is a buffer layer (or barrier layer) formed on the top surface of each of the source/drain regions 130 in a previous step, the buffer layer may be exposed by the recess R in this step.

Referring to FIG. 4I, a backside contact structure 270 may be formed in the recess R2 to be connected to the bottom surface of each of the source/drain regions 230. That is, the backside contact structure 270 may now replaces the placeholder structure 217 which is removed in the previous step.

The formation of the backside contact structure 270 may be performed by depositing in the recess R2 a metal or metal compound including copper (Cu), aluminum (Al), tungsten (W), molybdenum (Mo), ruthenium (Ru), cobalt (Co), etc., through, for example, CVD, PECVD, PVD, ALD, or a combination thereof, not being limited thereto.

Unlike in the intermediate semiconductor device 10 shown in FIG. 2E. the recess R2 formed in the intermediate semiconductor device 20 shown in FIG. 4H does not have a negative slope, and thus, the deposition of the meal or metal compound in the recess R2 may be performed with a reduced risk of incomplete filling of the recess R2 which may degrade a connection performance of a semiconductor device.

As the backside contact structure 270 may take the same shape of the placeholder structure 217, the backside contact structure 270 may also have a positive slope at its side surface, but without a negative slope, that is, the "fat Y" profile. In contrast, similar to the shape of the placeholder structure 270 in a cross-section view in the channel-width direction (i.e., D2 direction) along a line Z2-Z2' shown in FIG. 4I, the backside contact structure 270 may take a pillar shape having both side surfaces are vertically plane, as shown in FIG. 5B.

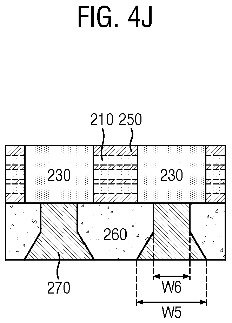

Referring to FIG. 4J, the intermediate semiconductor device 20 obtained in the previous step may be flipped upside down so that the backside contact structures 270 and the isolation structure 760 may be disposed below the source/drain regions 230 to form a semiconductor device.

In the semiconductor device 20, a lower width W5 of the backside contact structure 270, which may equal to the upper width W3 of the recess R2 (FIG. 4H), in the D1 direction may be greater than an upper width W6 of the backside contact structure 270, which may be equal to the lower width W4 of the recess R2 (FIG. 4H), in the D1 direction. This is because the backside contact structure 270 may have a side surface in a positive slope from a bottom surface thereof. In contact, the backside contact structure 270 may have width W7 which is a uniform or constant or a substantially uniform or constant along the D2 direction as shown in FIG. 5B without increasing the footprint of the backside contact structure 270 in the D2 direction.

In the above embodiment described in reference to FIGS. 3 to 5A-5B, the backside contact structure 270 is formed such that the width of an upper portion (corresponding to the lower portion P2 of the placeholder structure 217 of FIG. 4) is substantially equal to the width of a lower portion (corresponding to the segment of the placeholder structure 217 having the positive-slope side surface S 1 of FIG. 4) in the channel-width cross-section view, while the width of the upper portion is substantially uniform along a vertical downward direction and the width of the lower portion increases along the vertical downward direction in the channel-length cross-section view. However, the disclosure is not limited thereto. According to an embodiment, the backside contact structure may be similarly formed such that the width of the upper portion is substantially equal to the width of the lower portion in the channel-length cross-section view, while the width of the upper portion is substantially uniform along the vertical downward direction and the width of the lower portion increases along the vertical downward direction in the channel-length cross-section view.

Further, in the above embodiment, both of the backside contact structures 270 shown in FIGS. 4I and 4J have the "fat Y" profile. However, according to an embodiment, only one among the two backside contact structures 270 may be formed to have the "fat Y" profile.

In the above embodiments, a transistor structure shown in the intermediate semiconductor device 20 is a nanosheet transistor structure. However, the disclosure is not limited thereto. According to embodiments, the backside contact structure 270 of the above embodiment may apply to different types of transistor structure such as FinFET, a stacked field-effect transistor including a lower field-effect transistor and an upper field-effect transistor stacked thereon, not being limited thereto.

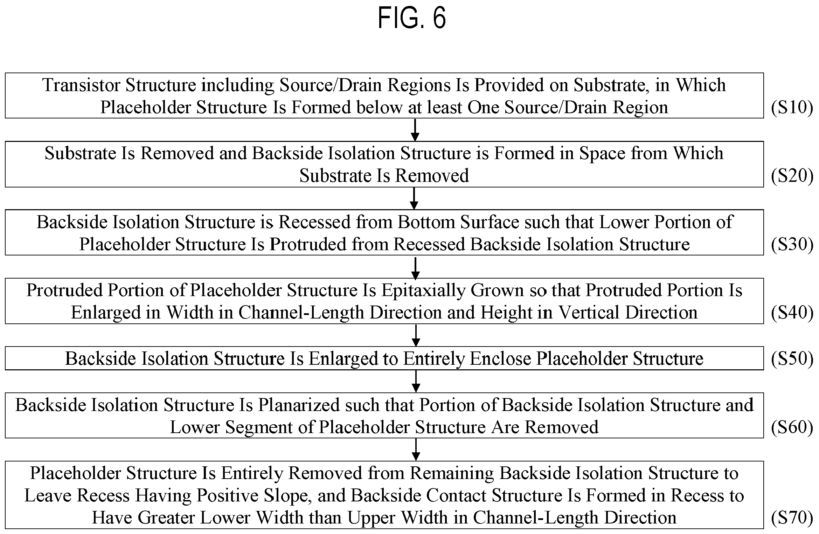

FIG. 6 is a flowchart illustrating a method of manufacturing a semiconductor device including a backside contact structure, according to embodiments.

In operation S 10, a transistor structure including source/drain regions is provided on a substrate, in which a placeholder structure is formed at a position below at least one source/drain region. See FIG. 4A.

The placeholder structure may be formed in a hole provided in the substrate where a backside contact structure is to be formed. A material forming the placeholder structure may include silicon germanium (SiGe).

In operation S20, the substrate is removed through, for example, dry etching or wet etching and a backside isolation structure is formed in a space from which the substrate is removed. In order to facilitate this removal operation and subsequent operations, the transistor structure may be flipped upside down to place the substrate to face in an upward direction. See FIGS. 4B and 4C

In operation S30, the backside isolation structure is recessed from a bottom surface such that a lower portion of the placeholder structure is protruded from the recessed backside isolation structure. See FIG. 4D.

In operation S40, the protruded portion of the placeholder structure is epitaxially grown so that the protruded portion is enlarged in a width in a channel-length direction and a height in a vertical direction. See FIG. 4E.

By this epitaxial growth, the enlarged portion of the placeholder structure may have an upper segment having a side surface in a positive slope and a lower segment having a side surface in a negative slope.

In operation S50, the backside isolation structure is enlarged to entirely enclose the placeholder structure. See FIG. 4F.

In operation S60, the backside isolation structure is planarized such that a portion of the backside isolation structure and the lower segment of the placeholder structure are removed. See FIG. 4G.

In operation S70, the placeholder structure is entirely removed from the remaining backside isolation structure to leave a recess having a positive slope, and a backside contact structure is formed in the recess to have a greater lower width than an upper width in the channel-length direction.

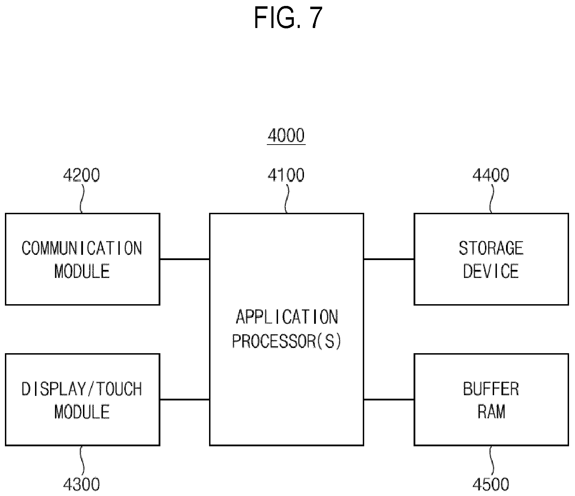

FIG. 7 is a schematic block diagram illustrating an electronic device including a backside contact structure, as shown in FIGS. 4I and 5B, according to an embodiment.

Referring to FIG. 7, an electronic device 4000 may include at least one application processor 4100, a communication module 4200, a display/touch module 4300, a storage device 4400, and a buffer random access memory (RAM) 4500. The electronic device 4000 may be a mobile device such as a smartphone or a tablet computer, not being limited thereto, according to embodiments.

The application processor 4100 may control operations of the electronic device 4000. The communication module 4200 is implemented to perform wireless or wire communications with an external device. The display/touch module 4300 is implemented to display data processed by the application processor 4100 and/or to receive data through a touch panel. The storage device 4400 is implemented to store user data. The storage device 4400 may be an embedded multimedia card (eMMC), a solid state drive (SSD), a universal flash storage (UFS) device, etc. The storage device 4400 may perform caching of the mapping data and the user data as described above.

The buffer RAM 4500 may temporarily store data used for processing operations of the electronic device 4000. For example, the buffer RAM 4500 may be volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

The electronic device 4000 may further include at least one sensor such as an image sensor.

At least one component in the electronic device 4000 may include the semiconductor device in FIGS. 4I and 5B.

The foregoing is illustrative of example embodiments and is not to be construed as limiting the disclosure. Although some example embodiments have been described above, those skilled in the art will readily appreciate that many modifications are possible in the above embodiments without materially departing from the disclosure.

## Claims

1. A semiconductor device comprising:
a channel structure;
source/drain regions connected by the channel structure; and
a backside contact structure formed below at least one of the source/drain regions, wherein, in a 1^{st}-direction cross section view, a width of an upper portion of the backside contact structure close to the source/drain region is smaller than a width of a lower portion of the backside contact structure distant from the source/drain region,
wherein, in a 2^{nd}-direction cross-section view, widths of the upper portion and the lower portion of the backside contact structure are substantially uniform along a vertical downward direction, and
wherein the 1^{st} direction intersects the 2^{nd} direction.

2. The semiconductor device of claim 1, wherein, in the 2^{nd}-direction cross-section view, the width of the upper portion is substantially equal to the width of the lower portion.

3. The semiconductor device of claim 1 or 2, wherein, in the redirection cross-section view, the width of the upper portion is substantially uniform along the vertical downward direction, and the width of the lower portion increases along the vertical downward direction.

4. The semiconductor device of any one of claims 1 to 3, wherein, in the 1^{st}-direction cross-section view, the backside contact structure comprises a side surface in a positive slope from a bottom surface thereof.

5. The semiconductor device of claim 4, wherein, in the 1^{st}-direction cross-section view, the backside contact structure does not comprise a side surface in a negative slope from the bottom surface thereof.

6. The semiconductor device of claim 4 or 5, wherein, in the 2^{nd}-direction cross-section view, two opposite side surfaces of the backside contact structure are vertically plane.

7. The semiconductor device of any one of claims 1 to 6, further comprising a backside isolation structure surrounding the backside contact structure.

8. A semiconductor device comprising:
a channel structure;
source/drain regions connected by the channel structure; and
a backside contact structure formed below at least one of the source/drain regions, wherein, in a 1^{st}-direction cross-section view, the backside contact structure comprises a side surface in a positive slope from a bottom surface thereof,
wherein, in a 2^{nd}-direction cross-section view, widths of the upper portion and the lower portion of the backside contact structure are substantially uniform along a vertical downward direction, and
wherein the 1^{st} direction intersects the 2^{nd} direction.

9. The semiconductor device of claim 8, wherein, in the 1^{st}-direction cross-section view, a width of the upper portion of the backside contact structure is smaller than a width of the lower portion of the backside contact structure.

10. The semiconductor device of claim 8 or 9, wherein, in the 2^{nd}-direction cross-section view, the width of the upper portion of the backside contact structure is substantially equal to the width of the lower portion of the backside contact structure.

11. The semiconductor device of any one of claims 8 to 10, wherein, in the 1^{st}-direction cross-section view, the backside contact structure does not comprise a side surface in a negative slope from the bottom surface thereof.

12. The semiconductor device of any one of claims 8 to 11, wherein, in the 2^{nd}-direction cross-section view, two opposite side surfaces of the backside contact structure are vertically plane.

13. The semiconductor device of any one of claims 8 to 12, further comprising a backside isolation structure surrounding the backside contact structure. [A7]

14. A method of manufacturing a semiconductor device;
forming source/drain regions at both ends of a channel structure on a substrate;
forming a placeholder structure below at least one of the source/drain regions in the substrate;
replacing the substrate with a backside isolation structure;
epitaxially growing a lower portion of the placeholder structure, being closer to the source/drain region than an upper portion thereof, such that the lower portion has a 1^{st} side surface in a positive slope and a 2^{nd} side surface in a negative slope, connected to the 1^{st} side surface, from a bottom surface of the placeholder structure;
removing a section of the epitaxially-grown lower portion of the placeholder structure having the 2^{nd} side surface in the negative slope; and
replacing the placeholder structure, from which the section of the epitaxially-grown lower portion is removed, with a backside contact structure.

15. The method of claim 14, wherein the epitaxially growing the lower portion of the placeholder structure is performed such that a width and a height of the lower portion increase in a 1^{st} direction and in a vertical direction, respectively.
